# FASCICULE DE BREVET EUROPEEN

(11) **EP 2 715 822 B1**
(45) Date de publication et mention de la délivrance du brevet: **30.08.2017**
(21) Numéro de dépôt: 12724622.1
(22) Date de dépôt: 30.05.2012
(51) Int. Cl.: H01L 51/10, H01L 51/44

(54) **TRANSISTOR ORGANIQUE A ELECTRODES AYANT UN AGENCEMENT ET UNE FORME AMELIORES**
ORGANISCHER TRANSISOR MIT ELEKTRODEN MIT VERBESSERTEM LAYOUT UND FORM
ORGANIC TRANSISTOR COMPRISING ELECTRODES HAVING AN IMPROVED LAYOUT AND SHAPE

(30) Priorité: 01.06.2011 FR 1154828
(43) Date de publication de la demande: 09.04.2014
(73) Titulaire: Commissariat à l'Énergie Atomique et aux Énergies Alternatives, 75015 Paris (FR); ISORG, 38000 Grenoble (FR)
(72) Inventeur: BENWADIH, Mohammed, F-94500 Champigny sur Marne (FR)
(74) Mandataire: Ahner, Philippe
(86) Numéro de dépôt international: PCT/EP2012/060144
(87) Numéro de publication internationale: WO 2012/163965

(56) Documents cités:
- WO-A1-2011/052058
- WO-A2-2009/108002
- JP-A- 2009 076 854
- US-A1- 2005 269 568

## Description

### DOMAINE TECHNIQUE

La présente demande concerne le domaine des composants dotés d'une zone active à base de matériau polymère semi-conducteur située entre deux électrodes, en particulier celui des transistors dits « organiques ».

Elle prévoit un composant microélectronique dont les électrodes ont une forme et un agencement permettant d'améliorer ses performances en particulier en termes de rapport entre son courant à l'état passant ou dans son état de fonctionnement et de son courant à l'état bloqué ou dans son état hors fonctionnement.

### ÉTAT DE LA TECHNIQUE ANTÉRIEURE

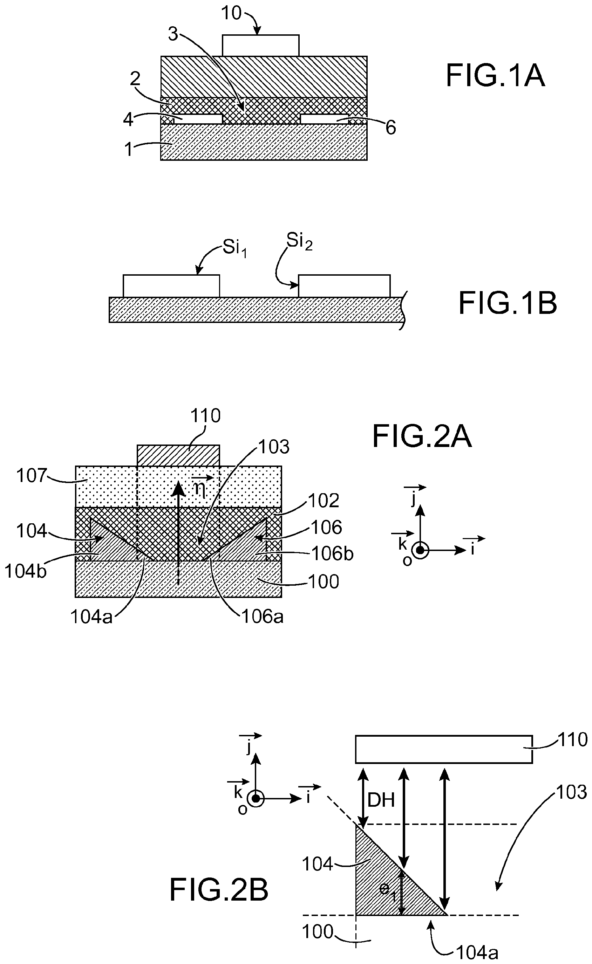

Un exemple de transistor organique à effet de champ mis en oeuvre suivant l'art antérieur est donné sur les figures 1A-1B.

Le transistor comporte une couche active 2 reposant sur un support 1 et recouvrant deux électrodes 4 et 6 de source et de drain.

La couche active 2 est formée d'un matériau de type polymère organique, ayant des propriétés semiconductrices. Ce transistor est agencé de sorte que son électrode de grille 10 est placée au dessus des électrodes de source 4 et de drain 6 (figure 1A).

Les électrodes 4 et 6 sont sous forme de blocs parallélépipédiques et comportent ainsi deux surfaces d'injections Si1 et Si2 de porteurs de charges dans ou depuis la zone de canal 3, une première surface d'injection Si1 correspondant à une face des blocs d'électrodes qui est parallèle au plan principal de la couche active 2 et en contact avec cette dernière, et une autre face des blocs d'électrodes qui est orthogonale au plan principal de la couche active 2 et en contact avec cette dernière.

Le document WO2009/108002 décrit un transistor organique dans lequel les électrodes de source et de drain ont des flancs inclinés.

Le document US2005/0269568 décrit un transistor organique ayant des électrodes de source et de drain avec une géométrie particulière.

WO2011/052058 décrit un transistor organique de type "bottom gate" dans lequel les électrodes de source et drain présentent des flancs inclinés de telle sorte que la distance entre les électrodes de source et drain augmentent au fur et à mesure qu'on se rapproche de la grille.

JP2009076854 décrit un transistor organique dans lequel les électrodes de source et de drain ont une forme en T. Le rapport Ion/Ioff est le rapport qui caractérise l'état passant et l'état bloqué d'un transistor. Le courant Ioff est le courant de fuite, que l'on cherche à minimiser, tandis que le courant Ion est le courant de saturation à une tension grille source donnée que l'on cherche à rendre maximum.

On cherche d'une manière générale à mettre en oeuvre des composants organiques ayant un rapport entre courant à l'état passant ou à l'état actif et courant à l'état bloqué ou à l'état inactif le plus important possible.

### EXPOSÉ DE L'INVENTION

L'invention concerne tout d'abord un composant microélectronique, en particulier organique, doté d'au moins une première électrode et d'au moins une deuxième électrode, la première électrode et la deuxième électrode étant séparées par une région d'une couche active à base d'au moins un matériau polymère, en particulier semi-conducteur, la première électrode et la deuxième électrode ayant une forme et un agencement prévus de sorte que la distance les séparant varie.

Ainsi, la région de la couche active séparant la première électrode et la deuxième électrode a une longueur encore appelée « dimension critique » D_{L} variable.

Par « dimension critique », on entend ici la plus faible dimension d'une couche ou d'un empilement de couches hormis son épaisseur.

Selon l'invention, le composant est un transistor, en particulier un transistor organique.

Dans ce cas, ladite première électrode est une électrode de source, tandis que la deuxième électrode est une électrode de drain, le transistor comprenant en outre une électrode de grille en regard de ladite région de matériau polymère séparant lesdites première électrode et deuxième électrode et d'au moins une portion des électrodes de source et de drain.

L'électrode de source et/ou l'électrode de drain peut ou peuvent être dotée(s) respectivement d'un flanc incliné réalisant un angle non nul avec le plan principal de la couche active.

L'électrode de source de drain peuvent être disposées sur un support et surmontées de l'électrode de grille. Selon un agencement particulier, l'électrode de grille peut être avantageusement située en regard seulement d'une portion des électrodes de source et de drain.

Ainsi une portion des électrodes de source et de drain située à proximité de la zone de canal du transistor peut être disposée en regard de l'électrode de grille, tandis que d'autres zones de l'électrode de source et de drain ne sont pas surmontées par l'électrode de grille et ne sont pas situées en regard de l'électrode de grille.

Selon une possibilité d'agencement l'électrode de source et l'électrode de drain peuvent avoir une forme de sorte que la distance séparant la première électrode et la deuxième électrode varie de manière linéaire, ou sensiblement linéaire.

L'agencement des électrodes de source et de drain est également prévu de sorte que la distance séparant l'électrode de source et l'électrode de drain augmente au fur et à mesure que l'on se rapproche de l'électrode de grille.

Cela permet de d'améliorer le transistor en termes de courant de saturation Ion tout en ayant un courant de fuite Ioff diminué. Dans cet agencement l'électrode de source et l'électrode de drain ont une forme de prisme à bases triangulaires, les bases triangulaires étant orthogonales à la couche active ou au plan principal de la couche active.

Selon une autre possibilité de mise en oeuvre, le transistor est formé de sorte que la distance séparant l'électrode de source et l'électrode de drain augmente dans une direction parallèle à l'électrode de grille et à la couche active. Dans ce cas l'électrode de source et l'électrode de drain ont une forme de prisme à bases triangulaires et parallèles au plan principal de la couche active.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A et 1B illustrent un transistor organique à effet de champ suivant l'art antérieur,
- les figures 2A-2D illustrent un exemple de transistor organique à effet de champ mis en oeuvre suivant l'invention, dans lequel l'agencement et la forme des électrodes est améliorée,
- la figure 3 illustre un autre exemple de transistor organique à effet de champ mis en oeuvre suivant l'invention, dans lequel l'agencement et la forme des électrodes est améliorée,
- la figure 4 illustre une photodiode organique, exemple ne faisant pas partie de la présente invention
- les figures 5A-5B illustrent un procédé de réalisation d'électrodes d'un composant organique mis en oeuvre suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de composant microélectronique suivant l'invention va à présent être décrit en liaison avec les figures 2A-2D.

Le composant microélectronique est, dans cet exemple, un transistor organique à effet de champ, formé sur un support 100, par exemple à base de polyéthylène naphtalate et d'épaisseur comprise par exemple entre 50 µm et 200 µm, avantageusement entre 100 µm et 150 µm.

Une couche active 102 à base d'au moins un matériau polymère semi-conducteur, par exemple tel que du TIPS (triisopropylsilyl pentacene) et d'épaisseur comprise par exemple entre 20 nanomètres et 200 nanomètres, repose sur le support 100.

Cette couche active 102 comporte une zone 103 formant un canal et située entre deux électrodes 104 et 106 de source et de drain, en regard d'une électrode 110 de grille.

Les électrodes de source 104 et de drain 106 reposent sur le support 100 et sont recouvertes par la couche active 102. Les électrodes de source 104 et de drain 106 peuvent avoir une épaisseur variant de 20 à 200 nanomètres.

Dans cet exemple de réalisation, les électrodes 104, 106 sont surmontées par une épaisseur de la couche active 102, cette épaisseur de la couche active 102 étant elle même surmontée d'une couche 107 de diélectrique de grille, par exemple une couche à base de polymère fluoré ou de polystyrène, par exemple de Cytop® de la société Asahi Glass et d'épaisseur comprise par exemple entre 400 nanomètres et 1 micromètre, tandis que l'électrode de grille 110 repose sur la couche de diélectrique 107, et est ainsi située au dessus des électrodes de source 102 et de drain 104.

L'électrode de grille 110 est disposée en regard d'une région 103 de la couche active et d'une portion 104a de l'électrode de source 104 et d'une portion 104b de l'électrode drain 106.

Ainsi dans cet exemple, seules les portions 104a et 106a des électrodes de source et de drain sont surmontées par l'électrode de grille 110 et en regard de cette électrode de grille 110. D'autres zones 104b, 106b des électrodes 104, 106 davantage éloignées de la zone de canal du transistor que les portions 104a et 106a et davantage rapprochées de la zone de diélectrique 107 de grille que les portions 104a, 106a, ne sont quant à elles pas disposées en regard de l'électrode de grille 110.

Cette électrode de grille 110 peut être formée par exemple à base d'Ag et avoir une épaisseur comprise par exemple entre 100 nanomètres et 5 micromètre (figure 2A).

Dans ce transistor, la distance D_{L} séparant l'électrode de source 104 et l'électrode de drain 106 est prévue de manière à être variable suivant où l'on se situe dans une région située entre ces dernières.

L'agencement des électrodes peut être prévu en particulier de sorte que la distance D_{L} séparant l'électrode de source 104 et l'électrode de drain 106 varie de manière linéaire.

Sur l'exemple de la figure 2B, une électrode du transistor, par exemple son électrode de source 104, a une épaisseur e₁ variable mesurée dans une direction orthogonale au plan principal de la couche active 102 (le plan principal de la couche active 102 étant un plan défini comme passant par cette couche et parallèle au plan [O*;i̅;k̅*] du repère orthogonal [O*;i̅;j̅;k̅*] sur les figures 2A-2D).

La distance D_{H} (mesurée dans une direction parallèle au vecteur *̅j̅*̅ du repère orthogonal [O*;i̅;j̅;k̅*]) séparant l'électrode de grille 110 de cette électrode 104 de source est ainsi variable et augmente au fur et à mesure que l'on se rapproche du centre de la région 103 située entre les électrodes 104 et 106 de source et de drain (figure 2B).

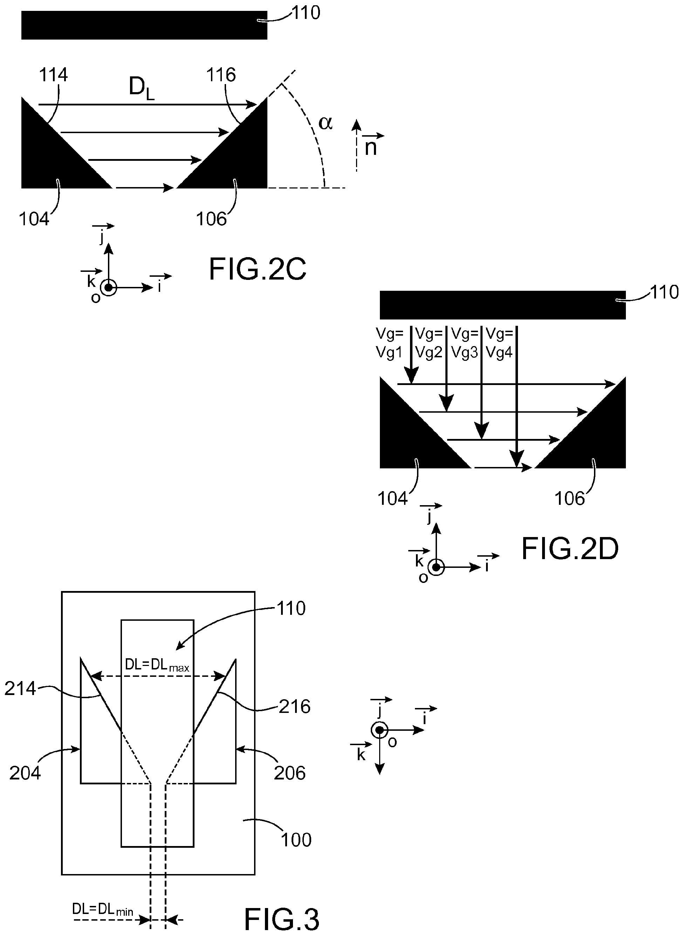

Sur l'exemple de la figure 2C, ce sont les deux électrodes 104 et 106 de source et de drain, qui ont une épaisseur variable et qui sont agencées de sorte que la distance D_{L} (mesurée dans une direction parallèle au vecteur *̅i̅*̅ du repère orthogonal [O*;i̅;j̅;k̅*]) séparant ces électrodes 104, 106 est variable et augmente au fur et à mesure que l'on se rapproche de l'électrode de grille 110.

Dans cet exemple de réalisation les électrodes 104 et 106 sont dotées de flancs inclinés et comprennent respectivement un premier flanc 114 incliné et un deuxième flanc 116 incliné situé en regard du premier flanc 114.

Chacun des flancs 114 et 116 réalise un angle non-nul avec une normale n au plan principal du support 100 ou de la couche active 102, ou un angle *α* inférieur à 90° avec un plan parallèle au plan principal du substrat 100 ou de la couche active 102.

L'angle *α* réalisé entre chacun des flancs 114 et 116 et le plan principal du support 100 ou de la couche active 102, peut être par exemple compris entre 15° et 85°, en particulier entre 30° et 60°, et par exemple de 45°.

Les électrodes de source 104 et de drain 106 ont ainsi, dans cet exemple, une forme de prisme, doté de bases triangulaires réalisant un angle non-nul, par exemple de 90°, avec le plan principal du support 100 ou de la couche active 102.

Dans cet exemple de réalisation, lorsque la grille 110 est polarisée selon un potentiel de grille Vg est le matériau semi-conducteur de la couche 102 est déplété jusqu'à une certaine profondeur. Des charges sont alors soumises à un champ électrique créé entre les électrodes 104 et 106 par application d'une tension drain-source VDS et constituent la réponse du transistor sous forme d'un courant.

Pour un potentiel de grille Vg=vg1 faible, seule la partie supérieure de la couche active à base de polymère semi-conducteur est déplétée. Cette partie supérieure de la couche active correspond à l'endroit où la distance D_{L} entre les électrodes 104 et 106 est la plus importante.

Ainsi, pour une tension drain-source VDS donnée, le champ électrique créé est faible, de sorte qu'il y a peu de charges collectées donc un courant Ioff du transistor à l'état bloqué très faible.

En revanche, pour un potentiel de grille Vg=Vg4 important, la zone déplétée est plus profonde, là où la distance D_{L} entre électrodes est la plus faible. Un maximum de charges est alors collecté puisque le champ électrique est plus fort, le courant à l'état passant Ion est plus élevé (figure 2D).

Un transistor doté d'une telle structure peut ainsi avoir à la fois un courtant Iₒₙ à l'état passant augmenté et un courant I_{off} à l'état bloqué diminué par rapport une structure de transistor organique ayant un agencement classique des électrodes.

Un autre exemple de transistor organique à effet de champ suivant l'invention, est donné sur la figure 3 (le transistor étant représenté en vue de dessus sur cette figure).

Ce transistor comporte une électrode de source 204 et une électrode de drain 206 séparées d'une distance DL variable, et diffère de celui décrit précédemment de part la forme de ses électrodes de source 204 et de drain 206.

Les électrodes de source 204 et de drain 206 sont, dans cet exemple, des plaques en forme de prismes à bases triangulaires, les bases des prismes étant parallèles au plan principal de la couche active 102 ou de la couche de support 100 (le plan principal de la couche active 102 étant un plan parallèle au plan [O*;i̅;k̅*] donné sur la figure 3).

Les électrodes 204 et 206 de source et de drain, sont agencées de sorte que la distance D_{L} (mesurée dans une direction parallèle au vecteur *̅i̅*̅ du repère orthogonal [O*;i̅;j̅;k̅*]) séparant ces électrodes 204 et 206 varie de manière linéaire, de sorte que lorsqu'on applique une tension aux électrodes 204, 206 le champ électrique entre les électrodes varie le long de la grille (dans une direction parallèle au vecteur *̅k̅*̅ du repère orthogonal [O*;i̅;j̅;k̅*]).

Dans cet exemple, la distance D_{H} (mesurée dans une direction parallèle au vecteur *̅j̅*̅ et qui n'est pas représentée sur la figure 3) séparant chaque électrode de source 204 ou de drain 206 de l'électrode de grille 210, peut être constante.

Dans cet exemple, quelle que soit la valeur de la tension appliquée sur la grille 210, le même volume de matériau organique semi-conducteur situé entre les électrodes est déplété. Le champ électrique créé par la tension de source et de drain VDS n'est cependant pas constant sur toute la longueur du transistor ou le long de la grille (dans une direction parallèle au vecteur *̅k̅*̅ du repère orthogonal [O*;i̅;j̅;k̅*])*.*

Une tension source-drain VDS=VDS2 peut être mise en oeuvre dans une zone où des pointes 217, 218 des électrodes sont situées en regard l'une de l'autre à une distance DL=DLmin l'une de l'autre, tandis qu'une tension VDS=VD1, plus faible, est mise en oeuvre dans une zone située entre les électrodes 204 et 206, où l'écartement entre ces dernières est le plus important.

Du fait de l'écartement variable entre les électrodes 204 et 206 dans le sens de la longueur du transistor, ces électrodes 204 et 206 peuvent être espacées d'une distance minimale DLmin qui peut être inférieure à l'écartement minimal généralement prévu pour les électrodes de transistors organiques.

L'écartement variable entre les électrodes 204 et 206 permet ainsi de limiter l'effet tunnel, et d'avoir des électrodes davantage rapprochées.

L'écartement minimal à l'endroit où les pointes des électrodes sont en regard, peut être au moins inférieur à 10 µm et par exemple de l'ordre de 5 µm. Les électrodes 204 et 206 peuvent être espacées d'une distance maximale DLmax par exemple de l'ordre de 55 µm. Un tel agencement permet d'obtenir un courant Ion à l'état passant plus important que celui d'un transistor classique dont les électrodes sont agencées selon un écartement constant par exemple de l'ordre de 30 µm.

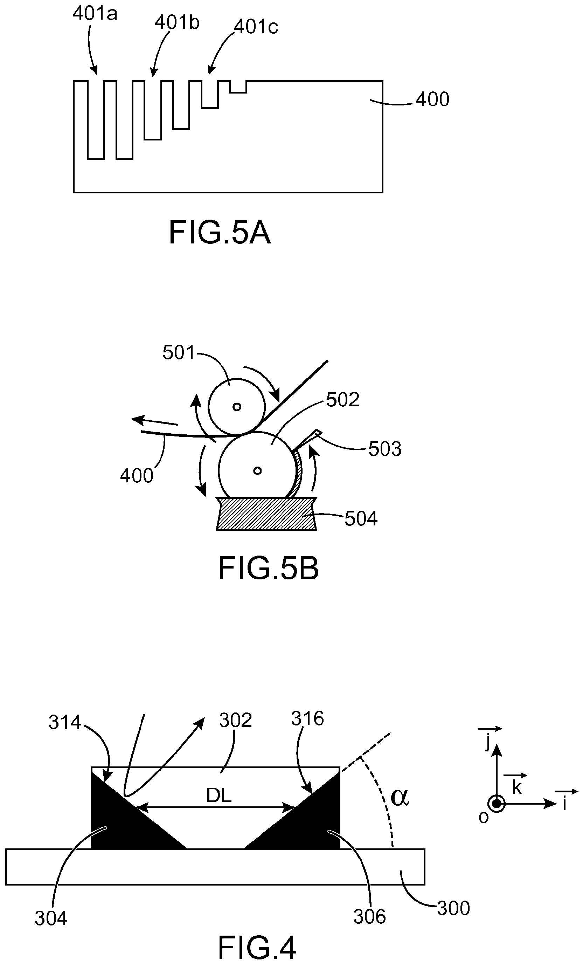

Un autre exemple de composant microélectronique, ne faisant pas partie de la présente invention, doté d'une zone active à base de polymère est donné sur la figure 4.

Dans cet exemple, le composant est une photodiode organique comportant des électrodes 304 et 306 reposant sur un support 300, et une couche active 302 située entre les électrodes.

La couche active 302 peut être à base un mélange de matériaux polymères, comportant un matériau polymère semi-conducteur de type N et un matériau polymère semi-conducteur de type P.

Le matériau polymère de la couche active 302 peut être un mélange d'un polymère de type P tel que par exemple du poly(3-hexylthiophène) ou poly(3-hexylthiophène-2,5-diyl) et communément appelé « P3HT », et d'un polymère de type N tel que par exemple du [6,6]-phényl-C₆₁-butanoate de méthyle et communément appelé « PCBM ».

La couche active 302 peut avoir une épaisseur comprise par exemple entre 50 et 400 nanomètres.

Les électrodes 304 et 306 sont dans cet exemple, sous forme de prismes à bases triangulaires, les bases triangulaires réalisant un angle non-nul, par exemple de 90° avec le plan principal de la couche de support ou au plan principal de la couche active 302 (le plan principal de la couche active 302 étant un plan parallèle au plan [O*;i̅;k̅*] donné sur la figure 4).

Les électrodes 304 et 306 de source et de drain, sont agencées de sorte que la distance D_{L} (mesurée dans une direction parallèle au vecteur *̅i̅*̅ du repère orthogonal [O*;i̅;j̅;k̅*]) séparant ces électrodes 304 et 306 est variable, et augmente, en particulier de manière linéaire, au fur et à mesure que l'on s'éloigne du support 300.

Dans cet exemple de réalisation, les électrodes 304 et 306 de la photodiode sont dotées de flancs inclinés à surface réfléchissante et comprennent respectivement un premier flanc 314 incliné à surface réfléchissante et un deuxième flanc 316 incliné à surface réfléchissante situé en regard du premier flanc 314 incliné.

Les flancs 314 et 316 réalisent un angle *α* non nul, par exemple compris entre 30° et 60°, par exemple de 45° avec le plan principal du support 300 ou de la couche active 302, et sont destinés à réfléchir un rayonnement lumineux ayant traversé la couche active 302. On peut augmenter ainsi la quantité d'excitons générés au sein du matériau de la couche active 302.

Les électrodes 304 et 306 peuvent être par exemple à base d'or et avoir une épaisseur variant de 20 nanomètres à 200 nanomètres.

Sous faible éclairement, des charges peuvent être créées dans une zone supérieure de la couche active 302, dans des régions où l'espacement DL entre les électrodes 304 et 306 est le plus important et égal à DLmax par exemple de l'ordre de 10 micromètres à 500 micromètres.

Sous fort éclairement, des excitons peuvent être formés dans toute l'épaisseur de la zone active 302. Dans des régions de la zone active 302 où la largeur est faible, il y aura beaucoup plus de charges collectées : l'illumination sera plus élevée.

En étant dotées en outre de surfaces réléchissantes 314, 316, les électrodes peuvent jouer un rôle de réflecteurs optiques et rediriger des photons vers l'intérieur de la zone active 302 pour augmenter le nombre de charges collectées.

Les électrodes 304 et 306 peuvent être formées pas exemple à base d'Au et être recouvertes d'une surface réfléchissante à base d'une couche d'Ag.

Un exemple de réalisation d'électrodes à flancs inclinés et destinées à être intégrées à un composant microélectronique à matériau actif organique, va à présent être donné en liaison avec les figures 5A-5B.

Un masque 400 à partir duquel on réalise ces électrodes peut être par exemple du poléthylène naphtalate.

On forme dans ce support une série de trous 401a, 401b, 401c de profondeurs différentes et décroissantes, que l'on remplie avec une encre conductrice par exemple telle qu'une encre contenant des nanoparticules d'or ou d'argent.

Le procédé peut être réalisé par héliogravure avec un dispostif doté d'un cylindre presseur 501 et d'un cylindre gravé entre lesquels on fait passer le masque 400 à imprimer pour former les trous 401a, 401b, 401c, le cylindre gravé passant dans un encrier 504 rempli d'encre conductrice. Le dispositif d'héliogravure peut être doté de moyens pour enlever le surplus d'encre. Puis, le motif formé est démoulé et reporté sur le support final des électrodes.

Selon un autre procédé, le masque peut être rempli d'un polymère qui est ensuite démoulé et sert de support au dépôt d'une couche conductrice.

## Revendications

1. Transistor doté d' une électrode source (104, 204, 304) et d'une électrode drain (106, 206, 306), l'électrode de source et l'électrode de drain étant séparées par une région d'une couche active (102, 302) à base d'au moins un matériau polymère semi-conducteur, la région de la couche active (102, 302) séparant les électrodes (104, 204, 304, 106, 206, 306) ayant une dimension critique (DL) variable, le transistor comprenant en outre une électrode de grille (110) en regard de ladite région de matériau polymère semi-conducteur séparant lesdites électrodes source et drain, et d'au moins une portion des électrodes de source et de drain, **caractérisé en ce que** les électrodes étant agencées selon l'une ou l'autre des alternatives suivantes :
a) l'électrode de source et l'électrode de drain ayant une forme de prisme à bases triangulaires et orthogonales au plan principal de la couche de matériau polymère de sorte que la dimension critique (DL), étant la dimension séparant l'électrode de source (104, 204) et l'électrode de drain (106, 206), augmentant au fur et à mesure que l'on se rapproche de l'électrode de grille, ou
b) la dimension critique (DL), étant la distance séparant l'électrode de source (104, 204) et l'électrode de drain (106, 206), augmentant dans une direction parallèle au plan principal de la couche active, l'électrode de source (204) et l'électrode de drain (206) ayant une forme de prisme à bases triangulaires et parallèles au plan principal de la couche de matériau polymère.

2. Transistor selon la revendication 1, dans lequel les électrodes sont agencées selon l'alternative a), l'électrode de source (104) et/ou l'électrode de drain (106) étant dotée(s) d'au moins un flanc incliné (116) réalisant un angle (α) non nul avec le plan principal de la couche active (102).

3. Transistor selon l'une des revendications 1 ou 2, l'électrode de source (104) et l'électrode de drain (106) ayant une forme de sorte que la distance séparant l'électrode de source et l'électrode de drain varie de manière linéaire.

4. Transistor selon la revendication 3, dans lequel l'électrode de grille surmonte et est située en regard d'une portion donnée (104a) de l'électrode de source (104) et d'une portion donnée (106a) de l'électrode de drain (106), d'autres portions (104b, 106b) de l'électrode de source et de l'électrode de drain n'étant pas situées en regard de l'électrode de grille (110).

## Patentansprüche

1. Transistor, enthaltend eine Source-Elektrode (104, 204, 304) und eine Drain-Elektrode (106, 206, 306), wobei die Source-Elektrode und die Drain-Elektrode durch einen Bereich einer Wirkschicht (102, 302) auf Basis von zumindest einem Polymer-Halbleitermaterial getrennt sind, wobei der die Elektroden (104, 204, 304, 106, 206, 306) trennende Bereich der Wirkschicht (102, 302) eine veränderliche, kritische Abmessung (DL) hat, wobei der Transistor ferner eine Gate-Elektrode (110) aufweist, die dem die Source-Elektrode und die Drain-Elektrode trennenden Bereich aus Polymer-Halbleitermaterial gegenüberliegt, und enthaltend zumindest einen Abschnitt der Source- und der Drain-Elektrode, **dadurch gekennzeichnet, dass** die Elektroden gemäß der einen oder anderen der nachfolgenden Varianten angeordnet sind:
a) die Source-Elektrode und die Drain-Elektrode haben eine Prismaform mit dreieckförmigen und orthogonal zur Hauptebene der Polymer-Materialschicht verlaufenden Grundflächen, so dass die kritische Abmessung (DL) die Abmessung ist, welche die Source-Elektrode (104, 204) und die Drain-Elektrode (106, 206) voneinander trennt, und mit zunehmender Annäherung an die Gate-Elektrode zunimmt,
oder
b) die kritische Abmessung (D) ist der Abstand, welcher die Source-Elektrode (104, 204) und die Drain-Elektrode (106, 206) voneinander trennt und in einer Richtung parallel zur Hauptebene der Wirkschicht zunimmt, wobei die Source-Elektrode (204) und die Drain-Elektrode (206) eine Prismaform mit dreieckförmigen und parallel zur Hauptebene der Polymer-Materialschicht verlaufenden Grundflächen haben.

2. Transistor nach Anspruch 1, wobei bei nach der Variante a) angeordneten Elektroden die Source-Elektrode (104) und/oder die Drain-Elektrode (106) mit zumindest einer geneigten Flanke (116) versehen sind, die einen Winkel (α) ungleich null mit der Hauptebene der Wirkschicht (102) einschließt.

3. Transistor nach einem der Ansprüche 1 oder 2, wobei die Source-Elektrode (104) und die Drain-Elektrode (106) eine solche Form haben, dass der die Source-Elektrode und die Drain-Elektrode trennende Abstand in linearer Weise variiert.

4. Transistor nach Anspruch 3, wobei die Gate-Elektrode einen gegebenen Abschnitt (104a) der Source-Elektrode (104) und einen gegebenen Abschnitt (106a) der Drain-Elektrode (106) überragt und diesen gegenüberliegt, wobei weitere Abschnitte (104b, 106b) der Source-Elektrode und der Drain-Elektrode nicht der Gate-Elektrode (110) gegenüberliegen.

## Claims

1. Transistor provided with at least a source electrode (104, 204, 304) and a drain electrode (106, 206, 306), the source electrode and the drain electrode being separated by a region of an active layer (102, 302) based on at least one semiconductor polymer material, the region of the active layer (102, 302) separating the electrodes (104, 204, 304, 106, 206, 306) having a variable critical dimension (DL), the transistor further comprising a gate electrode (110) opposite said region of semiconductor polymer material separating said source and drain electrodes and at least one portion of source and drain electrodes, **characterized in that**, the electrodes are arranged according to one or the other following alternatives:
a) the source electrode and the drain electrode having the form of a prism with triangular bases orthogonal to the principal plane of the layer of polymer material, so that the critical dimension (DL), being the distance separating the source electrode and the drain electrode, increases as the gate electrode is approached, or
b) the critical dimension (DL) being the distance separating the source electrode and the drain electrode, increasing in a direction parallel to the principal plane of the active layer, the source electrode (204) and the drain electrode (106, 206) having the form of a prism with triangular bases parallel to the principal plane of the layer of polymer material.

2. Transistor according to claim 1, the source electrode (104) and/or the drain electrode (106) being provided with at least one inclined flank (116) making a non-zero angle (α) with the principal plane of the active layer (102).

3. Transistor according to one of claims 1 or 2, the source electrode (104) and the drain electrode (106) having a form such that the distance separating the source electrode and the drain electrode varies linearly.

4. Transistor according to claim 3, wherein the gate electrode surmounts and is situated opposite a given portion (104a) of the source electrode (104) and a given portion (106a) of the drain electrode (106), other portions (104b, 106b) of the source electrode and drain electrode not being situated opposite the gate electrode (110).
